# FASCICULE DE BREVET EUROPEEN

(11) **EP 3 449 304 B1**
(45) Date de publication et mention de la délivrance du brevet: **19.10.2022**
(21) Numéro de dépôt: 17718953.7
(22) Date de dépôt: 25.04.2017
(51) Int. Cl.: G02B 27/01, H05K 1/02, H05K 1/05

(54) **AFFICHEUR TÊTE HAUTE**
HEAD-UP ANZEIGE
HEAD-UP DISPLAY

(30) Priorité: 26.04.2016 FR 1653671
(43) Date de publication de la demande: 06.03.2019
(73) Titulaire: Valeo Comfort and Driving Assistance, 94046 Créteil Cedex (FR)
(72) Inventeur: DELPIERRE, Laurent, 94046 Créteil CEDEX (FR); CORDUAN, Patrick, 94046 Créteil CEDEX (FR); GRANDCLERC, François, 94046 Créteil CEDEX (FR)
(74) Mandataire: Delplanque, Arnaud
(86) Numéro de dépôt international: PCT/EP2017/059836
(87) Numéro de publication internationale: WO 2017/186744

(56) Documents cités:
- WO-A1-2014/208438
- JP-A- H06 144 081
- JP-A- 2016 000 590
- US-A1- 2004 032 676
- US-A1- 2005 099 693

## Description

### DOMAINE TECHNIQUE AUQUEL SE RAPPORTE L'INVENTION

La présente invention concerne un afficheur tête haute pour véhicule automobile.

Elle concerne plus particulièrement un afficheur tête haute comprenant :
- une unité de génération image comportant au moins un émetteur de lumière,
- une plaque-support de circuit imprimé, sur laquelle ledit émetteur est monté, et
- un capteur de lumière adapté pour délivrer un signal représentatif d'une intensité lumineuse qu'il reçoit,
l'afficheur étant adapté à ce que la luminosité d'une image générée par l'unité de génération d'image soit commandée en fonction dudit signal.

### ARRIÈRE-PLAN TECHNOLOGIQUE

Pour le conducteur d'un véhicule automobile, il est particulièrement confortable de pouvoir visualiser des informations relatives au fonctionnement du véhicule, à l'état du trafic, ou autres, sans avoir pour cela à détourner son regard de la route faisant face au véhicule.

Il est connu dans ce but d'équiper un véhicule automobile avec un afficheur dit tête haute. Dans un tel afficheur, une image comportant les informations à afficher est générée par une unité de génération d'image. Cette image est alors superposée visuellement à l'environnement faisant face au véhicule, au moyen d'une réflexion partielle sur une lame semi-transparente située devant le conducteur, telle qu'un combineur disposé entre le parebrise du véhicule et les yeux du conducteur.

Afin que les informations ainsi affichées soient suffisamment lumineuses pour être correctement visualisées, sans pour autant risquer d'éblouir le conducteur, il est nécessaire d'adapter la luminosité de l'image ainsi superposée à l'environnement extérieur du véhicule à la luminosité de cet environnement luimême, qui varie fortement entre une conduite de jour et une conduite de nuit ou dans un tunnel.

Il est connu pour cela de munir l'afficheur tête haute d'un capteur de lumière, une unité de commande commandant alors la luminosité de l'image générée en fonction d'un signal acquis par le capteur de lumière, de manière à adapter la luminosité de cette image à une luminosité ambiante.

Plus particulièrement, il est connu de monter un émetteur de lumière, servant de source de lumière à l'unité de génération d'image, sur une première plaque-support de circuit imprimé, tandis que le capteur de lumière est monté sur une deuxième plaque-support de circuit imprimé. Un tel afficheur est divulgué par exemple dans WO 2014/208438 A1 ou bien dans JP06144081 A.

### OBJET DE L'INVENTION

Dans ce contexte, la présente invention propose un afficheur tel que défini en introduction, dans lequel le capteur de lumière est monté sur ladite plaque-support de circuit imprimé.

Cette plaque-support de circuit imprimé assure alors la fixation mécanique et la connexion électrique à la fois de l'émetteur de lumière au nombre de un au moins et du capteur de lumière.

Cet arrangement facilite avantageusement la fabrication de l'afficheur, par rapport à l'état de la technique susmentionné notamment, puisqu'une seule opération de montage est alors nécessaire pour installer à la fois ledit émetteur (au nombre de un au moins) et le capteur de lumière. Cet arrangement est par ailleurs particulièrement intéressant en termes de coût de fabrication, puisqu'il permet l'économie d'une plaque-support de circuit imprimé ainsi que des câbles électriques de liaison correspondants.

On peut prévoir que l'afficheur comprend en outre un boitier. Ladite plaque-support de circuit imprimé est alors située à l'intérieur du boitier, notamment pour être située au voisinage de l'unité de génération d'image. Le capteur de lumière est alors également situé à l'intérieur du boitier.

On peut prévoir alors que le boitier de l'afficheur présente une ouverture traversée par un rayonnement lumineux provenant de l'extérieur du boitier de l'afficheur pour parvenir jusqu'au capteur de lumière.

On peut prévoir aussi que l'afficheur comprend en outre un guide de lumière configuré pour collecter ledit rayonnement lumineux pour le guider jusqu'au capteur de lumière.

Le guide de lumière assure une collection avantageusement efficace du rayonnement lumineux provenant de l'extérieur du boitier, et dont l'intensité lumineuse est mesurée par le capteur de lumière.

Par ailleurs, il est préférable d'éviter qu'une partie de la lumière émise par ledit émetteur n'atteigne ledit capteur, car cette lumière perturberait la mesure de luminosité d'ambiance réalisée au moyen de ce capteur.

Grâce au guide de lumière, l'intensité lumineuse, provenant dudit émetteur et susceptible d'atteindre le capteur de lumière est avantageusement réduite.

De plus, grâce à ce guide de lumière, l'intérieur du boitier de l'afficheur n'est pas visible pour un utilisateur, tout en assurant que ledit rayonnement lumineux provenant de l'extérieur du boitier atteint le capteur de lumière. Cet arrangement est donc particulièrement intéressant en termes d'apparence extérieure de l'afficheur, puisque l'intérieur du boitier est ainsi masqué au regard de cet utilisateur.

Selon une caractéristique optionnelle de l'afficheur, le guide de lumière présente une face d'entrée au niveau de laquelle est collecté ledit rayonnement lumineux, cette face d'entrée étant située au niveau de ladite ouverture.

Le guide de lumière empêche alors l'entrée de corps étrangers, tels que des particules de poussière, à l'intérieur du boitier de l'afficheur, et masque de manière optimale, au regard d'un utilisateur, l'intérieur dudit boitier.

Selon l'invention, l'afficheur comprend également un ensemble optique de projection adapté pour projeter une image générée par l'unité de génération d'image, en direction d'une lame semi-transparente pour, avec la lame semi-transparente, former une image virtuelle dans le champ de vision d'un utilisateur.

On peut prévoir alors que le guide de lumière est distinct de la lame semi-transparente. On peut prévoir en outre que le guide de lumière est disjoint de la lame semi-transparente.

Il est préférable d'éviter qu'une partie de la lumière émise par l'unité de génération d'image, et réfléchie ensuite en partie sur la lame semi-transparente, n'atteigne ledit capteur, car cette lumière perturberait la mesure de luminosité d'ambiance réalisée au moyen de ce capteur.

Le fait que le guide de lumière est distinct de la lame semi-transparente évite alors avantageusement que la lumière émise par l'unité de génération d'image n'atteigne le capteur de lumière.

D'autres caractéristiques non limitatives et avantageuses de l'afficheur conforme à l'invention sont les suivantes :
- le boitier présente une face externe et la face d'entrée du guide de lumière est située au niveau de cette face externe ;
- le boitier présentant une face externe, le boitier comprend un conduit s'étendant depuis ladite face externe vers l'intérieur du boitier, pour le passage vers l'extérieur du boitier d'un rayonnement lumineux émis par l'unité de génération d'image, et la face d'entrée du guide de lumière est située au niveau d'une paroi de ce conduit ;
- ladite face externe est située, par rapport à l'intérieur du boitier, d'un même côté du boitier que la lame semi-transparente en position d'usage ;
- ladite plaque-support de circuit imprimé comprend une plaque en matériau thermiquement conducteur sur laquelle est appliquée une couche électriquement isolante ;
- la couche électriquement isolante étant recouverte, à l'opposé de la plaque en matériau thermiquement conducteur, d'une couche de connexion formée au moins en partie d'un matériau électriquement conducteur ;
- ledit émetteur comprend une diode électroluminescente ;
- l'afficheur comprend une pluralité d'émetteurs ;
- lesdits émetteurs sont disposés en ligne sur la plaque-support de circuit imprimé ; et
- l'afficheur est adapté à ce que la luminosité de l'image générée soit d'autant plus grande que l'intensité lumineuse reçue par ledit capteur est grande.

### DESCRIPTION DÉTAILLÉE D'UN EXEMPLE DE RÉALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue schématique partielle, en coupe, d'un afficheur mettant en œuvre les enseignements de l'invention ;
- la figure 2 est une autre vue schématique, en perspective, partielle, de l'afficheur de la figure 1 ;
- la figure 3 est une vue schématique en perspective d'une plaque-support de circuit imprimé de l'afficheur de la figure 1 ;
- la figure 4 est une vue schématique en perspective de la plaque-support de circuit imprimé de la figure 3 ainsi que d'un guide de lumière de l'afficheur de la figure 1, montrant leur positionnement l'un par rapport à l'autre ; et
- la figure 5 est une vue schématique de côté de la plaque-support de circuit imprimé de la figure 3.

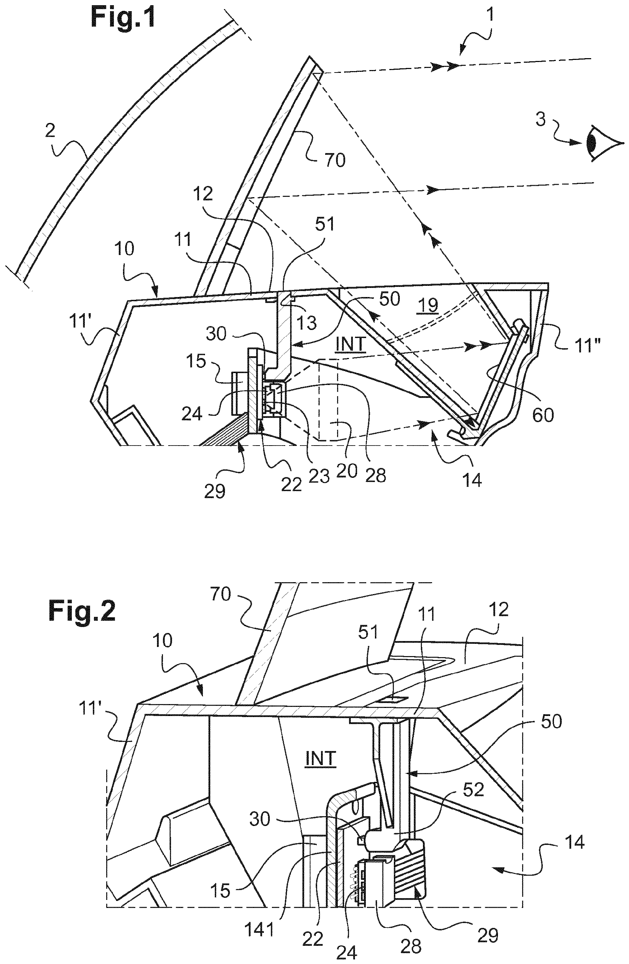

La figure 1 représente schématiquement les éléments principaux d'un afficheur 1, ici un afficheur tête haute, destiné à équiper un véhicule, par exemple un véhicule automobile, un train, un bateau tel qu'une péniche, un tramway ou un bus.

L'afficheur 1 comprend une unité de génération d'image qui comporte, ici, un écran 20 composé de plusieurs éléments dont les propriétés optiques de transmission ou de réflexion sont commandables, tel par exemple qu'un écran à cristaux liquides (ou LCD pour "Liquid Crystal Display") à transistors en couche mince (ou TFT pour "Thin-Film Transistor").

L'afficheur 1 comprend au moins un émetteur 23 de lumière, ici plusieurs. Chacun desdits émetteurs 23 de lumière, réalisé par exemple au moyen d'une diode électroluminescente, produit un rayonnement lumineux reçu au moins en partie par l'arrière de l'écran (ici à cristaux liquides), ce qui permet de générer une image.

L'afficheur 1 comprend également une plaque-support 22 de circuit imprimé (représentée schématiquement sur les figures 1 à 5), sur laquelle chacun desdits émetteurs 23 de lumière est monté.

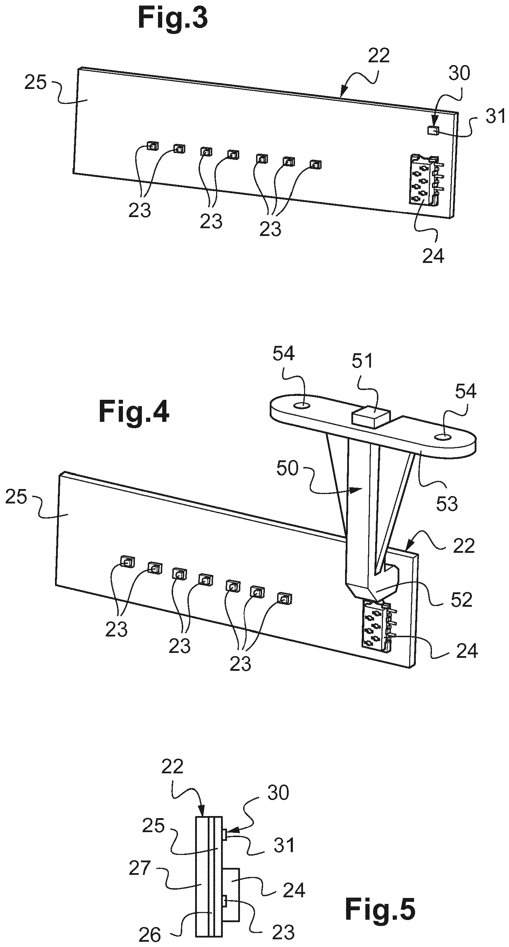

On peut prévoir en particulier que, comme ici, lesdits émetteurs 23 de lumière (montés sur la plaque-support 22 de circuit imprimé) sont disposés en ligne, le long de cette plaque-support 22 de circuit imprimé (figures 3 et 4).

Selon un mode de réalisation envisageable, ladite plaque-support 22 comprend, comme illustré schématiquement la figure 5, une plaque 27 en matériau thermiquement conducteur, par exemple en matériau métallique tel que de l'aluminium ou un alliage d'aluminium, sur laquelle est appliquée une couche électriquement isolante 26 tel qu'un vernis. La couche électriquement isolante 26 est alors recouverte, à l'opposé de la plaque 27 en matériau thermiquement conducteur, d'une couche de connexion 25 formée au moins en partie d'un matériau électriquement conducteur tel qu'un métal ou un alliage métallique. Chacun desdits émetteurs 23 de lumière est alors soudé sur la couche de connexion 25.

Dans ce cas, ladite plaque-support 22 peut par exemple être réalisée au moyen d'une plaque-support de circuit imprimé de type IMS (selon l'acronyme anglo-saxon de « Insulated Metal Substrate » ou substrat métallique isolé).

Grâce à ladite plaque 27 en matériau thermiquement conducteur, la plaque-support 22 autorise alors une évacuation avantageusement efficace d'une énergie thermique dégagée par lesdits émetteurs 23 de lumière, améliorant l'efficacité et la stabilité de fonctionnement de l'unité de génération d'image ainsi que sa longévité.

La plaque-support 22 de circuit imprimé est montée sur un support 14 permettant de la maintenir en position dans le boitier 10 de l'afficheur 1. Ce support 14 est formé ici d'un matériau thermiquement conducteur. Plus précisément, la plaque 27 en matériau thermiquement conducteur de ladite plaque-support 22 est appliquée contre une paroi 141 de ce support 14 (figure 2). Cette paroi 141 porte, sur une face opposée à ladite plaque-support 22, des ailettes 15 améliorant encore l'évacuation de l'énergie thermique dégagée par lesdits émetteurs 23 de lumière.

Un connecteur 24 est également monté sur la plaque-support 22 de circuit imprimé, par soudure, sur la couche de connexion 25 de ladite plaque-support 22.

L'afficheur 1 comprend également une unité de commande (non représentée) alimentant électriquement lesdits émetteurs 23 de lumière. Cette unité de commande est reliée électriquement à la plaque-support 22 de circuit imprimé au moyen d'un câble électrique. Ce câble électrique comprend un premier connecteur 28 (figures 1 et 2) et un deuxième connecteur (non représenté) reliés par une pluralité de fils conducteurs 29. Le premier connecteur 28 de ce câble est enfiché dans le connecteur 24 monté sur ladite plaque-support 22 qui a été mentionné ci-dessus.

Dans une variante non représentée, certains composants électroniques de l'unité de commande peuvent être montés directement sur ladite plaque-support de circuit imprimé. Dans le cadre de cette variante, le connecteur monté sur la plaque-support de circuit imprimé mentionné ci-dessus peut être utilisé non pas pour relier cette plaque-support à l'unité de commande, mais, par exemple, pour la relier à une source d'énergie électrique ou à un module électronique extérieur à l'afficheur.

Ici, l'afficheur 1 comprend également un ensemble optique de projection adapté pour projeter l'image générée par l'unité de génération d'image en direction d'une lame semi-transparente pour, avec la lame semi-transparente, former une image virtuelle dans le champ de vision d'un utilisateur.

On peut ainsi afficher des informations dans le champ de vision de l'utilisateur sans que celui-ci n'ait à détourner le regard. En pratique, cet utilisateur correspond ici au conducteur du véhicule.

L'ensemble optique de projection comprend ici un miroir de repliement 60. En variante, il pourrait comprendre une pluralité de miroirs et/ou d'autres éléments optiques.

La lame semi-transparente est ici mise en œuvre sous la forme d'un combineur 70, c'est-à-dire d'une plaque semi-transparente, disposée ici entre le pare-brise 2 du véhicule et les yeux 3 du conducteur.

On peut prévoir en variante que l'ensemble optique de projection projette directement l'image générée par l'unité de génération d'image en direction du pare-brise du véhicule, le combineur précité étant alors omis. Dans ce cas, la lame semi-transparente est ainsi mise en œuvre sous la forme du pare-brise du véhicule.

L'expression « lame semi-transparente » désigne ici une lame au moins partiellement transparente, présentant un niveau de transparence compris entre celui d'une lame complètement transparente, et celui d'une lame complètement opaque.

En plus d'être semi-transparente, cette lame est semi-réfléchissante, permettant ainsi de renvoyer en direction de l'utilisateur une partie au moins de la lumière produite par l'unité de génération d'image, comme cela est représenté schématiquement sur la figure 1.

L'image virtuelle, formée dans le champ de vision de l'utilisateur par l'ensemble optique de projection et la lame semi-transparente, est située à l'opposé de l'utilisateur par rapport à la lame semi-transparente.

Ici, pour le conducteur du véhicule, l'image virtuelle se forme au sein de l'environnement routier faisant face au véhicule, se superposant ainsi visuellement à cet environnement.

L'afficheur 1 comprend également un boitier 10 dans lequel sont logés l'unité de génération d'image et l'ensemble optique de projection.

Ce boitier 10, représenté partiellement sur la figure 1, cache au regard de l'utilisateur les éléments de l'afficheur 1 logés dans le boitier 10 et protège ces éléments de l'afficheur 1 de corps étrangers tels que des poussières.

Le boitier 10 est formé de plusieurs parois 11, 11', 11", ici optiquement opaques, séparant l'intérieur INT du boitier 10 de l'extérieur de celui-ci.

Le boitier 10 présente, du côté de la lame semi-transparente en position d'usage, une face externe 12.

Plus précisément, la lame semi-transparente, ici le combineur 70, s'étend, en position d'usage, à l'extérieur du boitier 10, en saillie par rapport à cette face externe 12, comme le montrent les figures 1 et 2. Cette face externe 12 est ici présentée par une paroi principale 11 supérieure, globalement plane du boitier 10.

Le terme « supérieure » désigne des éléments, ou parties d'éléments de l'afficheur, situés, par rapport au boitier 10 (plus précisément par rapport à l'intérieur INT du boitier 10), d'un même côté du boitier que la lame semi-transparente en position d'usage. De tels éléments, en particulier la paroi principale 11 supérieure, peuvent ainsi être visibles pour l'utilisateur. Dans le cas particulier où l'afficheur 1 est installé dans le véhicule à proximité d'un tableau de bord de ce dernier (d'un côté du pare-brise 2 opposé à un toit du véhicule), le terme « supérieure » désigne des éléments, ou parties d'éléments de l'afficheur, situés vers le haut de l'afficheur 1, relativement à une direction verticale ascendante.

On peut prévoir de manière optionnelle que le combineur 70 est monté mobile par rapport au boitier 10 entre sa position d'usage et une position rétractée, le combineur 70 dans sa position rétractée étant logé dans le boitier 10.

La plaque-support 22 de circuit imprimé est située à l'intérieur INT du boitier.

Ici, elle s'étend approximativement perpendiculairement à la paroi principale 11 supérieure du boitier. Ladite plaque-support 22 est disposée, par rapport à la paroi principale 11 supérieure du boitier, à l'opposé de la lame semi-transparente. Elle est disposée en outre, ici, de sorte que la ligne d'émetteurs 23 de lumière susmentionnée s'étende approximativement perpendiculairement à la paroi principale 11 supérieure du boitier.

Ici, l'afficheur 1 comprend également un conduit 19 (figure 1), s'étendant depuis la face externe 12 du boitier en direction de l'intérieur INT du boitier 10. Ce conduit 19 débouche au niveau de la face externe 12 du boitier 10. Ce conduit 19 est prévu pour le passage d'un rayonnement lumineux qui émerge de l'écran 20 de l'unité de génération d'image et qui est renvoyé vers le combineur 70 par l'ensemble optique de projection pour former l'image virtuelle IMV. Ce conduit 19 évite notamment qu'un rayonnement lumineux parasite, autre que celui destiné à former l'image virtuelle IMV, ne sorte du boitier 10 de l'afficheur.

L'afficheur 1 comprend également un capteur 30 de lumière, tel qu'une photodiode ou un phototransistor, adapté pour délivrer un signal représentatif d'une intensité lumineuse qu'il reçoit. Le capteur 30 de lumière est disposé de manière à recevoir un rayonnement lumineux provenant de l'extérieur de l'afficheur 1.

L'afficheur 1 est adapté à ce que la luminosité de l'image générée par l'unité de génération d'image soit commandée en fonction du signal délivré par le capteur 30 de lumière.

La luminosité de l'image générée peut ainsi être adaptée à une luminosité ambiante, mesurée au moyen du capteur 30, ce qui permet d'assurer la visibilité de l'image virtuelle, même lorsque la luminosité ambiante varie.

Plus précisément, l'afficheur 1 est adapté ici à ce que la luminosité de l'image générée soit d'autant plus grande que l'intensité lumineuse reçue par ledit capteur 30 est grande.

La luminosité de l'image générée est adaptée ici en ajustant l'intensité lumineuse produite par lesdits émetteurs 23 de lumière au moyen d'une adaptation de la puissance électrique qui les alimente.

En particulier, ici, l'unité de commande (qui alimente électriquement lesdits émetteurs 23 de lumière) est programmée pour commander l'ajustement de cette puissance électrique en fonction du signal délivré par le capteur 30 de lumière, de manière que la luminosité de l'image générée est d'autant plus grande que l'intensité lumineuse reçue par ledit capteur 30 est grande.

En variante, l'unité de commande peut être adaptée pour commander l'ajustement de cette puissance électrique en fonction d'un signal de commande extérieur reçu par l'afficheur, ce signal de commande extérieur étant déterminé en fonction du signal délivré par le capteur 30 de lumière.

Selon une caractéristique particulièrement remarquable de l'afficheur 1, le capteur 30 de lumière est monté sur ladite plaque-support 22 de circuit imprimé.

Cette plaque-support 22 de circuit imprimé assure alors à elle seule la fixation mécanique et la connexion électrique desdits émetteurs 23 de lumière ainsi que du capteur 30 de lumière, ce qui est particulièrement intéressant en termes de fabrication puisqu'une seule opération de montage et une seule plaque-support sont alors nécessaires pour installer à la fois lesdits émetteurs 23 de lumière (au nombre de un au moins) et le capteur 30 de lumière.

Le capteur 30 de lumière est soudé ici sur la couche de connexion 25 de ladite plaque-support 22.

Le câble électrique précité, dont on rappelle qu'il relie la plaque-support 22 à l'unité de commande, est adapté à transmettre le signal délivré par le capteur 30 de lumière à l'unité de commande.

Le capteur 30 de lumière présente une surface sensible 31 (au niveau de laquelle le capteur 30 reçoit ladite intensité lumineuse) qui s'étend ici approximativement parallèlement à plaque-support 22 de circuit imprimé. La surface sensible 31 (figure 3) du capteur 30 est donc ici approximativement perpendiculaire à la paroi principale 11 supérieure de l'afficheur 1.

Le boitier 10 présente ici une ouverture 13 (figure 1) traversée par le rayonnement lumineux provenant de l'extérieur du boitier 10 de l'afficheur 1 pour parvenir jusqu'au capteur 30 de lumière. Cette ouverture 13 est ici ménagée à travers ladite paroi principale 11 supérieure du boitier 10, et débouche ainsi sur ladite face externe 12 de ce dernier.

En variante encore, la surface sensible du capteur de lumière peut présenter une orientation différente de celle décrite ci-dessus. Cette surface sensible peut par exemple s'étendre sensiblement parallèlement à la paroi dans laquelle est ménagée ladite ouverture.

L'afficheur 1 peut comprendre également, comme ici, un guide de lumière 50, configuré pour collecter ledit rayonnement lumineux et pour le guider jusqu'au capteur 30 de lumière.

Grâce au guide de lumière 50, le capteur 30 de lumière peut être positionné sur ladite plaque-support 22 de circuit imprimé (à l'intérieur INT du boitier 10), avec les avantages susmentionnés que cela implique, tout en recevant principalement et de manière efficace ledit rayonnement lumineux provenant de l'extérieur du boitier 10 de l'afficheur 1.

De plus, grâce à ce guide de lumière 50, l'intérieur INT du boitier 10 de l'afficheur 1 n'est pas visible pour un utilisateur, ce qui améliore son apparence extérieure.

En variante, le guide de lumière pourrait toutefois être omis. Dans le cadre de cette variante, on peut prévoir que ladite ouverture est ménagée au droit de la surface sensible du capteur de lumière, cette surface sensible étant par exemple sensiblement parallèle à la paroi dans laquelle est ménagée l'ouverture.

Le guide de lumière 50 présente ici une face d'entrée 51, au niveau de laquelle est collecté ledit rayonnement lumineux. Cette face d'entrée 51 est située au niveau de ladite ouverture 13. Plus précisément, comme on peut le voir sur la figure 2, la face d'entrée 51 du guide de lumière 50 affleure ici la face externe 12 sur laquelle débouche cette ouverture 13.

En variante, au lieu d'être ménagée au niveau de la paroi principale supérieure du boitier, ladite ouverture pourrait être ménagée au niveau d'une autre paroi du boitier. En particulier, cette ouverture pourrait être ménagée au niveau d'une paroi formant le conduit susmentionné (dont on rappelle qu'il est prévu pour le passage, vers l'extérieur du boitier, du rayonnement lumineux émergeant de l'écran à cristaux liquides). Selon cette variante, la face d'entrée du guide de lumière est alors située au niveau de cette paroi du conduit.

Le guide de lumière 50 est ici distinct, et disjoint de la lame semi-transparente. Cela évite que la lumière émise par l'unité de génération d'image, et qui traverse la lame semi-transparente ou est réfléchie par celle-ci, n'atteigne le capteur 30 de lumière. Cet arrangement est particulièrement intéressant, car si une partie de la lumière émise par l'unité de génération d'image atteignait le capteur 30 de lumière, cela perturberait la mesure de luminosité ambiante réalisée au moyen de ce capteur 30.

Le guide de lumière 50 présente ici une forme globalement allongée, de section approximativement régulière (ici rectangulaire), s'étendant depuis la face d'entrée 51 du guide de lumière jusqu'à une face de sortie du guide de lumière située en vis-à-vis de la surface sensible 31 du capteur 30 de lumière (figure 4).

Le guide de lumière 50 est formé d'une matière transparente par exemple une matière plastique transparente telle que du polycarbonate transparent ou du polyméthacrylate de méthyle (ou PMMA) transparent.

Ledit rayonnement lumineux collecté au niveau de la face d'entrée 51 est guidé jusqu'à la face de sortie notamment par réflexion totale interne au niveau de surfaces externes, latérales, du guide de lumière 50.

Le guide de lumière 50 présente ici un coude 52, en l'occurrence sensiblement à angle droit, permettant de rediriger ledit rayonnement lumineux vers la surface sensible 31 du capteur 30 de lumière.

Le guide de lumière 50 présente également, ici, du côté de sa face d'entrée 51, une semelle 53. Cette semelle 53 est fixée du côté intérieur de la paroi du boitier dans laquelle est ménagée ladite ouverture 53 (ici ladite paroi principale 11 supérieure). Cette fixation est réalisée ici au moyen d'organes de fixation tels que des vis, traversant des trous 54 pratiqués dans cette semelle 53.

En variante, au lieu d'être fixé au boitier, le guide de lumière pourrait être fixé à ladite plaque-support de circuit imprimé, ou encore être fixé à la fois au boitier et à ladite plaque-support de circuit imprimé.

La forme du guide de lumière 50 dépend en particulier de la position de ladite ouverture 13 par rapport à la plaque-support 22 de circuit imprimé, puisque le guide de lumière 50 relie optiquement cette ouverture 13 au capteur 30 de lumière monté sur cette plaque-support.

Aussi, on peut prévoir en variante que le guide de lumière présente une forme détaillée différente de celle décrite précédemment, notamment lorsque ladite ouverture est située, sur le boitier, à une autre position que celle décrite ci-dessus.

## Revendications

1. Afficheur tête haute (1) comprenant:
- une unité de génération d'image comportant au moins un émetteur de lumière (23),
- un ensemble optique de projection (60) adapté pour projeter une image générée par l'unité de génération d'image, en direction d'une lame semi-transparente (70) pour, avec la lame semi-transparente, former une image virtuelle dans le champ de vision d'un utilisateur
- une plaque-support (22) de circuit imprimé, sur laquelle ledit émetteur (23) est monté, et
- un capteur (30) de lumière adapté pour délivrer un signal représentatif d'une intensité lumineuse qu'il reçoit,
l'afficheur (1) étant adapté à ce que la luminosité d'une image générée par l'unité de génération d'image soit commandée en fonction dudit signal,
**caractérisé en ce que** le capteur (30) de lumière est monté sur ladite plaque-support (22) de circuit imprimé.

2. Afficheur tête haute (1) selon la revendication 1, comprenant en outre un boitier (10), ladite plaque-support de circuit imprimé étant située à l'intérieur du boitier, le boitier présentant une ouverture (13) traversée par un rayonnement lumineux provenant de l'extérieur du boitier de l'afficheur pour parvenir jusqu'au capteur (30) de lumière.

3. Afficheur tête haute (1) selon la revendication 2, comprenant en outre un guide de lumière (50), configuré pour collecter ledit rayonnement lumineux pour le guider jusqu'au capteur (30) de lumière.

4. Afficheur tête haute (1) selon la revendication 3, dans lequel le guide de lumière (50) présente une face d'entrée (51) au niveau de laquelle est collecté ledit rayonnement lumineux, la face d'entrée (51) du guide de lumière étant située au niveau de ladite ouverture (13).

5. Afficheur tête haute (1) selon l'une des revendications 3 et 4, dans lequel le boitier (10) présente une face externe (12), la face d'entrée (51) du guide de lumière (50) étant située au niveau de cette face externe (12).

6. Afficheur tête haute (1) selon l'une des revendications 3 et 4 dans lequel, le boitier (10) présentant une face externe (12), le boitier (10) comprend un conduit (19) s'étendant depuis ladite face externe (12) vers l'intérieur (INT) du boitier (10) pour le passage vers l'extérieur du boitier (10) d'un rayonnement lumineux émis par l'unité de génération d'image, la face d'entrée (51) du guide de lumière (50) étant située au niveau d'une paroi ce conduit (19).

7. Afficheur tête haute (1) selon la revendication 1 ou 2 prise dans la dépendance de l'une des revendications 3 à 6, dans lequel le guide de lumière (50) est distinct de la lame semi-transparente (70).

8. Afficheur tête haute (1) selon l'une des revendications 5 à 7 dans lequel ladite face externe (12) est située, par rapport à l'intérieur (INT) du boitier (10), d'un même côté du boitier (10) que la lame semi-transparente (70) en position d'usage.

9. Afficheur tête haute (1) selon l'une des revendications 1 à 8, dans lequel ladite plaque-support (22) de circuit imprimé comprend une plaque (27) en matériau thermiquement conducteur sur laquelle est appliquée une couche électriquement isolante (26), la couche électriquement isolante (26) étant recouverte, à l'opposé de la plaque (27) en matériau thermiquement conducteur, d'une couche de connexion (25) formée au moins en partie d'un matériau électriquement conducteur.

10. Afficheur tête haute (1) selon l'une des revendications 1 à 9, dans lequel ledit émetteur (23) comprend une diode électroluminescente.

11. Afficheur tête haute (1) selon l'une des revendications 1 à 10, comprenant une pluralité d'émetteurs (23) disposés en ligne sur la plaque-support (22) de circuit imprimé.

12. Afficheur tête haute (1) selon l'une des revendications 1 à 11, adapté à ce que la luminosité de l'image générée soit d'autant plus grande que l'intensité lumineuse reçue par ledit capteur (30) est grande.

## Patentansprüche

1. Head-up-Anzeige (1), umfassend:
- eine Bilderzeugungseinheit, die wenigstens einen Lichtemitter (23) aufweist,
- eine optische Projektionsanordnung (60), die geeignet ist, ein Bild, das von der Bilderzeugungseinheit erzeugt wird, in Richtung einer halbtransparenten Scheibe (70) zu projizieren, um mit der halbtransparenten Scheibe ein virtuelles Bild im Sichtfeld eines Benutzers zu bilden,
- eine Leiterplatte (22), auf der der Emitter (23) angebracht ist, und
- einen Lichtsensor (30), der geeignet ist, ein Signal zu liefern, das für eine Lichtstärke repräsentativ ist, die er empfängt,
wobei die Anzeige (1) dafür geeignet ist, dass die Helligkeit eines Bilds, das von der Bilderzeugungseinheit erzeugt wird, in Abhängigkeit von dem Signal gesteuert wird,
**dadurch gekennzeichnet, dass** der Lichtsensor (30) auf der Leiterplatte (22) angebracht ist.

2. Head-up-Anzeige (1) nach Anspruch 1, ferner umfassend ein Gehäuse (10), wobei sich die Leiterplatte im Inneren des Gehäuses befindet, wobei das Gehäuse eine Öffnung (13) aufweist, durch die eine Lichtstrahlung hindurchgeht, die von außerhalb des Gehäuses der Anzeige kommt, um bis zum Lichtsensor (30) zu gelangen.

3. Head-up-Anzeige (1) nach Anspruch 2, ferner umfassend einen Lichtleiter (50), der dazu ausgebildet ist, die Lichtstrahlung zu sammeln, um sie bis zum Lichtsensor (30) zu leiten.

4. Head-up-Anzeige (1) nach Anspruch 3, wobei der Lichtleiter (50) eine Eintrittsfläche (51) aufweist, an der die Lichtstrahlung gesammelt wird, wobei sich die Eintrittsfläche (51) des Lichtleiters an der Öffnung (13) befindet.

5. Head-up-Anzeige (1) nach einem der Ansprüche 3 und 4, wobei das Gehäuse (10) eine Außenseite (12) aufweist, wobei sich die Eintrittsfläche (51) des Lichtleiters (50) an dieser Außenseite (12) befindet.

6. Head-up-Anzeige (1) nach einem der Ansprüche 3 und 4, wobei, das Gehäuse (10) aufweisend eine Außenseite (12), das Gehäuse (10) eine sich von der Außenseite (12) zum Inneren (INT) des Gehäuses (10) erstreckende Leitung (19) zum Durchleiten einer von der Bilderzeugungseinheit emittierten Lichtstrahlung zum Äußeren des Gehäuses (10) umfasst, wobei sich die Eintrittsfläche (51) des Lichtleiters (50) an einer Wand dieser Leitung (19) befindet.

7. Head-up-Anzeige (1) nach Anspruch 1 oder 2 in Abhängigkeit von einem der Ansprüche 3 bis 6, wobei der Lichtleiter (50) von der halbtransparenten Scheibe (70) gesondert ist.

8. Head-up-Anzeige (1) nach einem der Ansprüche 5 bis 7, wobei sich die Außenseite (12) bezogen auf das Innere (INT) des Gehäuses (10) auf ein und derselben Seite des Gehäuses (10) wie die halbtransparente Scheibe (70) in Gebrauchsposition befindet.

9. Head-up-Anzeige (1) nach einem der Ansprüche 1 bis 8, wobei die Leiterplatte (22) eine Platte (27) aus wärmeleitendem Material umfasst, auf der eine elektrisch isolierende Schicht (26) aufgebracht ist, wobei die elektrisch isolierende Schicht (26) gegenüber von der Platte (27) aus wärmeleitendem Material von einer Verbindungsschicht (25) bedeckt ist, die wenigstens teilweise von einem elektrisch leitenden Material gebildet ist.

10. Head-up-Anzeige (1) nach einem der Ansprüche 1 bis 9, wobei der Emitter (23) eine Leuchtdiode umfasst.

11. Head-up-Anzeige (1) nach einem der Ansprüche 1 bis 10, umfassend eine Mehrzahl von Emittern (23), die in einer Linie auf der Leiterplatte (22) angeordnet sind.

12. Head-up-Anzeige (1) nach einem der Ansprüche 1 bis 11, die dafür geeignet ist, dass das erzeugte Bild um so größer ist, je größer die Lichtstärke ist, die vom Sensor (30) empfangen wird.

## Claims

1. Head-up display (1) comprising:
- an image generation unit comprising at least one light emitter (23),
- an optical projection assembly (60) adapted to project an image generated by the image generation unit in the direction of a semi-transparent strip (70) in order to form, with the semi-transparent strip, a virtual image in the field of view of a user,
- a printed circuit support plate (22), on which said emitter (23) is mounted, and
- a light sensor (30) adapted to deliver a signal which is representative of a luminous intensity which it receives,
the display (1) being adapted so that the luminosity of an image generated by the image generation unit is controlled depending on said signal,
**characterized in that** the light sensor (30) is mounted on said printed circuit support plate (22).

2. Head-up display (1) according to Claim 1, further comprising a casing (10), said printed circuit support plate being located inside the casing, the casing having an opening (13) traversed by light radiation originating outside the casing of the display in order to reach the light sensor (30).

3. Head-up display (1) according to Claim 2, further comprising a light guide (50) configured to collect said light radiation in order to guide it up to the light sensor (30).

4. Head-up display (1) according to Claim 3, wherein the light guide (50) has an inlet face (51), in the region of which said light radiation is collected, the inlet face (51) of the light guide being located in the region of said opening (13).

5. Head-up display (1) according to one of Claims 3 and 4, wherein the casing (10) has an outer face (12), the inlet face (51) of the light guide (50) being located in the region of this outer face (12).

6. Head-up display (1) according to one of Claims 3 and 4, wherein, the casing (10) having an outer face (12), the casing (10) comprises a channel (19) extending from said outer face (12) towards the inside (INT) of the casing (10) for light radiation emitted by the image generation unit to pass through towards the outside of the casing (10), the inlet face (51) of the light guide (50) being located in the region of a wall of this channel (19) .

7. Head-up display (1) according to Claim 1 or 2 as depended on by one of Claims 3 to 6, wherein the light guide (50) is distinct from the semi-transparent strip (70) .

8. Head-up display (1) according to one of Claims 5 to 7, wherein said outer face (12) is located, with respect to the inside (INT) of the casing (10), on the same side of the casing (10) as the semi-transparent strip (70) in the use position.

9. Head-up display (1) according to one of Claims 1 to 8, wherein said printed circuit support plate (22) comprises a plate (27) made of thermally conductive material, to which an electrically insulating layer (26) is applied, the electrically insulating layer (26) being covered, opposite the plate (27) made of thermally conductive material, with a connection layer (25) formed at least in part from an electrically conductive material.

10. Head-up display (1) according to one of Claims 1 to 9, wherein said emitter (23) comprises a light-emitting diode.

11. Head-up display (1) according to one of Claims 1 to 10, comprising a plurality of emitters (23) arranged in a line on the printed circuit support plate (22).

12. Head-up display (1) according to one of Claims 1 to 11, adapted so that, the greater the luminous intensity received by said sensor (30), the greater the luminosity of the generated image.
